# EUROPEAN PATENT SPECIFICATION

(11) **EP 3 464 214 B1**
(45) Date of publication and mention of the grant of the patent: **17.02.2021**
(21) Application number: 17724579.2
(22) Date of filing: 23.05.2017
(51) Int. Cl.: C04B 35/14, C04B 35/111, C04B 35/26, C04B 35/453, C04B 35/46, C04B 35/505, C04B 35/58, C04B 35/565, C04B 35/581, C04B 35/584, C04B 35/622, C04B 35/626, C04B 35/634, G03F 7/004, G03F 7/029, G03F 7/031, G03F 7/38, C04B 35/632, C04B 35/486, G03F 7/00

(54) **PRODUCTION OF A PHOTOCURABLE FORMULATION FOR ADDITIVE MANUFACTURING**
HERSTELLUNG EINER LICHTHÄRTBAREN FORMULIERUNG ZUR ADDITIVEN FERTIGUNG
PRODUCTION D'UNE FORMULATION PHOTODURCISSABLE DE FABRICATION ADDITIVE

(30) Priority: 03.06.2016 EP 16172930
(43) Date of publication of application: 10.04.2019
(73) Proprietor: BASF SE, 67056 Ludwigshafen (DE)
(72) Inventor: STUHRMANN, Bjoern, 67056 Ludwigshafen (DE); SCHROF, Wolfgang, 67056 Ludwigshafen (DE); SCHMIDT, Kris, Granada Hills, LA 91344 (US)
(74) Representative: BASF IP Association
(86) International application number: PCT/EP2017/062448
(87) International publication number: WO 2017/207366

(56) References cited:
- EP-A1- 0 536 086
- FR-A1- 3 028 851
- US-A- 6 117 612

## Description

The present invention relates to a method for the production of a photocurable formulation (F) for the use in an additive manufacturing process. In this method a ceramic dispersion (CD) comprising at least one ceramic material, at least one first acrylate and at least one dispersant is mixed with a solution (S) which comprises at least one second acrylate and at least one photoinitiator to obtain the photocurable formulation (F).

A task often encountered in very recent times is the rapid production of prototypes and/or small series. Additive manufacturing processes are additive layer-by-layer processes for fabrication, designed to transpose existing three-dimensional computer-aided design data (CAD), ideally without a manual diversion of forming directly and rapidly into work pieces.

For additive manufacturing different processes are known which can be subdivided into light radiation - based processes and processes without the use of light radiation.

With light radiation - based processes a curable liquid composition is cured layer by layer preferably with an UV light emitting laser, UV light emitting diodes (LED), or an UV lamp, either by fast scanning of an UV illumination spot or by large-area UV light projection using micromirror arrays. As curable liquid composition for example monomers or monomer mixtures are used. The polymerization of said monomers is induced by means of the UV radiation.

Other additive manufacturing processes are for example the Photopolymer Jetting Process (PPJ), the Selective Laser Sintering Process (SLS) and the Fused Filament Fabrication Process (FFF) also known as Fused Deposition Modelling (FDM).

EP 2 151 214 discloses light curing slips for the stereolithographic preparation of dental ceramics. The slip comprises from 5 to 65 % by weight of a polymerizable binder, from 0.001 to 1 % by weight of a photoinitiator and from 35 to 90 % by weight of surface-modified ceramic and/or glass ceramic particles. The ceramic or glass ceramic particles preferably have a particle size in the range from 10 to 200 nanometers. The slip can furthermore comprise one or more dispersants and pigments.

EP 2 404 590 as well discloses a light-curing ceramic slip for the stereolithographic preparation of high-strength ceramics. This slip comprises from 1 to 30 % by weight of at least one acidic monomer, from 0 to 50 % by weight of at least one non-acidic radically polymerizable monomer, from 0.001 to 2 % by weight of a photoinitiator and from 30 to 90 % by weight of ceramic and/or glass ceramic particles. The particle sizes of the ceramic or glass ceramic particles are preferably in the range from 10 to 200 nanometers. The slip can furthermore comprise dispersants and pigments.

US 2010/0003619 discloses systems and methods for fabricating three-dimensional objects. An exemplary UV-curable resin according to US 2010/0003619 comprises 76 % by weight of a silica powder with an average particles size of 7 microns, 19.17 % by weight of SR 238 monomer, 2.34 % by weight of SR 494 monomer, 1.58 % by weight of Variquat C 55 dispersant and 0.86 % by weight of Irgacure 819.

FR3028851 A1 describes a process for manufacturing a coloured zirconia based ceramic by stereolithography from a mixture comprising zirconia, a photocurable binder, a photoinitiator and a plasticizer.

US6117612A discloses the preparation of a multilayer ceramic green body involving using photopolymerizable ceramic resin having low viscosity and containing sinterable powders, monomers, photoinitiator and dispersant.

The formulations described in the state of the art are highly filled with ceramic powder. Therefore, these formulations tend to precipitate the ceramic component with time forming sediment on the bottom of the delivery or printing device container. This sediment layer is often very difficult to re-disperse. This makes it nearly impossible to use a formulation from which the ceramic component is precipitated in an additive manufacturing process. The described precipitation is particularly strong if ceramic particles are large (micron sized) as is required for certain metal casting processes that are performed with the printed molds.

Therefore, the technical problem underlying the present invention was to provide an improved method for the preparation of a photocurable formulation which does not have the above mentioned disadvantages of the prior art or has them only to a significantly reduced extend. Moreover, the method should be carried out in a simple, safe and cost efficient manner.

This object is achieved by a method for the production of a photocurable formulation (F) for the use in an additive manufacturing process, comprising the steps
a) provision of a ceramic dispersion (CD) comprising the following components
   (A) at least one ceramic material having a D50 value of at least 2 µm,
   (B1) at least one first acrylate
   (C) at least one dispersant
b) provision of a solution (S) comprising the following components
   (B2) at least one second acrylate
   (D) at least one photoinitiator
c) mixing the ceramic dispersion (CD) provided in step a) and the solution (S) provided in step b) to obtain the photocurable formulation (F).

The photocurable formulation (F) is preferably photocurable by exposure to an UV light source. Another object of the present invention is therefore a method for the production of a photocurable formulation (F) wherein the photocurable formulation (F) is photocurable by exposure to an UV light source

The ceramic dispersion (CD) and the solution (S) can be mixed in step c) by common mixing devices. This makes the inventive method very simple, robust and cost efficient.

Furthermore, it has surprisingly been found that the ceramic dispersion (CD) does not collapse even over a longer period of time although the ceramic material has a D50 value of at least 2 µm.

The obtained photocurable formulation (F) has a sufficient low viscosity for the use in an additive manufacturing process.

Moreover, the photocurable formulation (F) obtained by the inventive method can be directly used in an additive manufacturing process without the necessity to add further components and is stable against sedimentation during the process for at least 12 hours.

The three-dimensional parts obtained from the photocurable formulation (F) in an additive manufacturing process are of high precision. Moreover, uncured photocurable formulation (F) can be easily removed from the moldings obtained during the additive manufacturing process. Furthermore, by additive manufacturing techniques obtained moldings of the photocurable formulation (F) are mechanically stable so that they can easily be processed further, for example easily be de-bindered and sintered.

The ceramic dispersion (CD) and the solution (S) are stable during delivery and can be stored for at least 12 weeks.

The ceramic dispersion (CD) has been found to be particular stable if its viscosity is relatively high, for example in the range from 15 to 50 Pas measured with a Brookfield Viscometer (spindle 64 at 6 rpm) at a temperature of 25°C.

The inventive method will be described in more detail hereinafter.

### Step a)

In step a) a ceramic dispersion (CD) is provided. This ceramic dispersion (CD) comprises at least one ceramic material having a D50 value of at least 2 µm as component (A), at least one first acrylate as component (B1) and at least one dispersant as component (C).

The terms "at least one ceramic material" and "component (A)" for the purpose of the present invention are synonymous and are used interchangeably throughout the present invention.

The same holds true for the terms "at least one first acrylate" and "component (B1)" as well as for the terms "at least one dispersant" and "component (C)". The terms "at least one first acrylate" and "component (B1)" for the purpose of the present invention are synonymous and are used interchangeably throughout the present invention. The terms "at least one dispersant" and "component (C)" for the purpose of the present invention are synonymous as well and are used interchangeably throughout the present invention.

Components (A), (B1) and (C) will be discussed in more detail below.

The ceramic dispersion (CD) can comprise components (A), (B1) and (C) in any ratio. Preferably the ceramic dispersion (CD) provided in step a) of the inventive method comprises in the range from 74.9 to 95 % by weight of component (A), in the range from 0.1 to 25 % by weight of component (B1) and in the range from 0.1 to 15 % by weight of component (C), based on the sum of the percent by weight of components (A), (B1) and (C), preferably based on the total weight of the ceramic dispersion (CD).

Particularly preferably the ceramic dispersion (CD) provided in step a) comprises in the range from 78 to 92 % by weight of component (A), in the range from 3 to 20 % by weight of component (B1) and in the range from 0.4 to 11 % by weight of component (C), based on the sum of the percent by weight of components (A), (B1) and (C), preferably based on the total weight of the ceramic dispersion (CD).

More preferably the ceramic dispersion (CD) provided in step a) comprises in the range from 81 to 89 % by weight of component (A), in the range from 6 to 15 % by weight of component (B1) and in the range from 0.7 to 7 % by weight of component (C), based on the sum of the percent by weight of components (A), (B1) and (C), preferably based on the total weight of the ceramic dispersion (CD).

In a preferred embodiment, preferably the ceramic dispersion (CD) provided in step a) of the inventive method comprises in the range from 57 to 90 % by volume of component (A), in the range from 10 to 42 % by volume of component (B1) and in the range from 0.1 to 15 % by volume of component (C), based on the sum of the percent by volume of components (A), (B1) and (C), preferably based on the total volume of the ceramic dispersion (CD).

Particularly preferably the ceramic dispersion (CD) provided in step a) comprises in the range from 62.1 to 84.1 % by volume of component (A), in the range from 10 to 37.2 % by volume of component (B1) and in the range from 0.7 to 15 % by volume of component (C), based on the sum of the percent by volume of components (A), (B1) and (C), preferably based on the total volume of the ceramic dispersion (CD).

More preferably the ceramic dispersion (CD) provided in step a) comprises in the range from 66.3 to 78.9 % by volume of component (A), in the range from 11.3 to 28.1 % by volume of component (B1) and in the range from 1.3 to 13.2 % by volume of component (C), based on the sum of the percent by volume of components (A), (B1) and (C), preferably based on the total volume of the ceramic dispersion (CD).

Another object of the present invention is therefore a method wherein the ceramic dispersion (CD) provided in step a) comprises in the range from 74.9 to 95 % by weight of component (A) in the range from 0.1 to 25 % by weight of component (B1) and in the range from 0.1 to 15 % by weight of component (C), based on the sum of the percent by weight of components (A), (B1) and (C).

The percentages by weight of components (A), (B1) and (C) comprised in the ceramic dispersion (CD) usually add up to 100% by weight. Moreover the percentages by volume of components (A), (B1) and (C) comprised in the ceramic dispersion (CD) usually add up to 100 % by volume.

In a preferred embodiment the ceramic dispersion (CD) does not comprise a photoinitiator, in particular, no component (D).

Another object of the present invention is therefore also a method wherein the ceramic dispersion (CD) does not comprise a photoinitiator.

The provision of the ceramic dispersion (CD) in step a) can be carried out by any method known to the skilled person. Generally, the ceramic dispersion (CD) is provided by mixing the components (A), (B1) and (C). Preferred are high shear mixing equipments, preferably with shear rates in the range from 20 to 100 s⁻¹. Suitable mixing devices are known to the skilled person. Examples of suitable mixing devices include kneaders, planetary mixers and vertical mixers (e.g. Eirich intensive mixers).

Preferably, the ceramic dispersion (CD) is provided by first mixing components (B1) and (C). Component (A) is then added and mixed stepwise. The temperature during mixing is preferably at most 60° C, particularly preferred in the range from 5 to 60 °C.

The ceramic dispersion (CD) usually comprises component (A) dispersed in components (B1) and (C).

Therefore, components (B1) and (C) are the continuous phase and component (A) is the dispersed phase in the ceramic dispersion (CD).

The ceramic dispersion (CD) can be provided at any temperature below the decomposition temperature of component (B1) and component (C).

Preferably the ceramic dispersion (CD) is provided in step a) at a temperature in the range from 5 to 40 °C, more preferably in the range from 10 to 35 °C and most preferably in the range of 15 to 30 °C.

The viscosity of the ceramic dispersion (CD) is preferably in the range from 15 to 50 Pas, particularly preferably in the range from 18 to 40 Pas and more preferably in the range from 20 to 30 Pas measured with a Brookfield Viscometer (spindle type 64 at 6 rpm) at a temperature of 25 °C.

The ceramic dispersion (CD) is preferably stable against sedimentation during storage for at least twelve weeks at a temperature between -20 to 80 °C.

### Step b)

In step b) a solution (S) is provided which comprises at least one second acrylate as component (B2) and at least one photoinitiator as component (D).

The terms "at least one second acrylate" and "component (B2)" for the purpose of the present invention are synonymous and are used interchangeably throughout the present invention.

The same holds true for the terms "at least one photoinitiator" and "component (D)". The terms "at least one photoinitiator" and "component (D)" for the purpose of the present invention are as well synonymous and are used interchangeably throughout the present invention.

Component (B2) and component (D) will be described in more detail below.

The solution (S) provided in step b) for example, comprises in the range from 75 to 99.9 % by weight of component (B2) and in the range from 0.1 to 25 % by weight of component (D) based on the sum of the percent by weight of components (B2) and (D), preferably based on the total weight of the solution (S).

Preferably, the solution (S) provided in step b) comprises in the range from 80 to 99.9 % by weight of component (B2) and in the range from 0.1 to 20 % by weight of component (D) based on the sum of the percent by weight of components (B2) and (D), preferably based on the total weight of the solution (S).

Particularly preferably, the solution (S) provided in step b) comprises in the range from 84 to 97 % by weight of component (B2) and in the range from 3 to 16 % by weight of component (D) based on the sum of the percent by weight of components (B2) and (D), preferably based on the total weight of the solution (S).

Another object of the present invention is therefore also a method wherein the solution (S) provided in step b) comprises in the range from 75 to 99.9 % by weight of component (B2) and in the range from 0.1 to 25 % by weight of component (D), based on the sum of the percent by weight of components (B2) and (D).

The solution (S) that is provided in step b) preferably comprises component (C2), at least one second dispersant.

The terms "component (C2)" and "at least one second dispersant" are synonymous and are used interchangeably throughout the present invention.

For example, the solution (S) comprises in the range from 0.01 to 50 % by weight of component (C2), preferably in the range from 0.01 to 30 % by weight and particularly preferably in the range from 0.01 to 15 % by weight, based on the total weight of the solution (S).

For component (C2) the embodiments and preferences given below for component (C) hold true.

Another object of the present invention is therefore also a method wherein the solution (S) provided in step b) furthermore comprises component (C2) at least one dispersant.

The solution (S) provided in step b) can furthermore comprise at least one additive. Suitable at least one additives are known to the skilled person and are preferably selected from the group consisting of UV absorbers.

Another object of the present invention is therefore also a method wherein the solution (S) provided in step b) furthermore comprises at least one additive selected from the group consisting of UV absorbers.

Suitable UV absorbers are known to the skilled person. Preferred UV absorbers are selected from the group consisting of 2-hydroxyphenyl-benzophenones, 2-(2-hydroxyphenyl)-benzotriazoles and 2-hydroxyphenyl-s-triazines. These UV absorbers are known to the skilled person and are obtainable under the trade names Chimassorb® and Tinuvin® by BASF SE.

If the solution (S) comprises at least one additive, the solution (S) comprises the additive preferably in an amount in the range from 0.1 to 3.7 % by weight, more preferably in the range from 0.1 to 2.5% by weight and particularly preferably in the range from 0.1 to 1.3 % by weight, based on the total weight of the solution (S).

The percentages by weight of component (B2), component (D) and optionally component (C2) and the at least one additive, comprised in the solution (S) usually add up to 100 % by weight.

In a preferred embodiment the solution (S) does not comprise a ceramic material, in particular, no component (A).

Another object of the present invention is therefore also a method wherein the solution (S) provided in step b) does not comprise a ceramic material.

The solution (S) usually comprises the component (D) dissolved in component (B2).

The provision of the solution (S) can be carried out by any method known to the skilled person.

Preferably the solution (S) is provided by mixing components (B2) and (D) and optionally component (C2) and at least one additive. The mixing can be carried out by any method known to the skilled person, for example with a propeller agitator, paddle mixer or dispersion disk. The components are added together in any order and then mixed for 1 to 2 hours, or until homogeneous.

The provision of the solution (S) can be carried out at any temperature below the decomposition temperature of components (B2) and (D).

Preferably, the solution (S) is provided in step b) at a temperature in the range from 5 to 40°C, particularly preferably in the range from 10 to 35°C and more preferably in the range from 15 to 30 °C.

### Component (A)

Component (A) is at least one ceramic material having a D50-value of at least 2 µm.

"At least one ceramic material" within the context of the present invention means precisely one ceramic material and also mixture of two or more ceramic materials.

The at least one ceramic material has a D50-value of at least 2 µm, preferably the D50-value is in the range from 2 µm to 10 µm.

In another preferred embodiment the component (A) has
a D10-value in the range from 0.01 to 5 µm
a D50-value in the range from 2 to 10 µm and
a D90-value in the range from 20 to 35 µm.

Particularly preferably component (A) has
a D10-value in the range from 0.1 to 2 µm
a D50-value in the range from 4 to 10 µm and
a D90-value in the range from 25 to 35 µm.

Within the context of the present invention, the "D10-value" is the particles size at which 10 vol.-% of the particles based on the total volume of the particles are smaller than or equal to the D10-value and 90 vol.-% of the particles based on the total volume of the particles are greater than the D10-value. Within the context of the present invention, the "D50-value" is the particles size at which 50 vol.-% of the particles based on the total volume of the particles are smaller than or equal to the D50-value and 50 vol.-% of the particles based on the total volume of the particles are greater than the D50-value. Within the context of the present invention, the "D90-value" is the particles size at which 90 vol.-% of the particles based on the total volume of the particles are smaller than or equal to the D90-value and 10 vol.-% of the particles based on the total volume of the particles are greater than the D90-value.

The D10-, D50- and D60-value is measured by laser diffraction using a Malvern Mastersizer 2000 particle size analyzer. Immediately prior to measurements, the ceramic material is dispersed in deionized water by stirring and ultrasonic treatment for 10 minutes.

Component (A) is at least one ceramic material. Within the context of the present invention a ceramic material means a non-metallic compound of a metal or a first metalloid and a non-metal or a second metalloid.

"A metal" means precisely one metal and also a mixture of two or more metals. The same applies to "a non-metal", "a first metalloid" and "a second metalloid". "A non-metal" means precisely one non-metal and also a mixture of two or more non-metals. "A first metalloid" means precisely one first metalloid and also a mixture of two or more first metalloids. "A second metalloid" means precisely one second metalloid and also a mixture of two or more second metalloids.

Suitable metals are known to the skilled person. Preferably, the metal is selected from the group consisting of Zirconium, Aluminum, Zinc, Iron, Titanium and Yttrium.

Suitable non-metals are as well known to the skilled person. The non-metal according to the present invention can be selected from any non-metal of the periodic table, preferably the non-metal is selected from the group consisting of carbon, nitrogen, oxygen, phosphorous and sulfur, particularly preferably the non-metal is oxygen.

Metalloids are as well known to the skilled person. The first metalloid and the second metalloid can be selected from any metalloid of the periodic table. Preferably, the first metalloid and/or the second metalloid are selected from the group consisting of boron and silicon. It should be clear that the first metalloid and the second metalloid differ from each other. For example, if the first metalloid is boron then the second metalloid is selected from any other metalloid of the periodic table of the elements besides boron.

Preferably component (A) is selected from the group consisting of oxides, carbides, borides, nitrides and silicides, particularly preferred, component (A) is selected from the group consisting of oxides.

In a preferred embodiment component (A) is selected from the group consisting of SiO₂, ZrO₂, Al₂O₃, ZnO, Fe₂O₃, Fe₃O₄, Y₂O₃, TiO₂, SiC, Si₃N₄, TiB and AlN.

Particularly preferred, component (A) is selected from the group consisting of SiO₂, ZrO₂, Al₂O₃, ZnO, Fe₂O₃, Fe₃O₄, Y₂O₃ and TiO₂. More particularly preferred component (A) is selected from the group consisting of SiO₂ and ZrO₂.

Another object of the present invention is therefore also a method wherein component (A) is selected from the group consisting of SiO₂, ZrO₂, Al₂O₃, ZnO, Fe₂O₃, Fe₃O₄, Y₂O₃, TiO₂, SiC, Si₃N₄, TiB and AlN.

### Components (B1) and (B2)

Component (B1) is at least one first acrylate.

"At least one first acrylate" within the context of the present invention means precisely one first acrylate and also a mixture of two or more first acrylates.

Component (B2) is at least one second acrylate.

"At least one second acrylate" within the context of the present invention means precisely one second acrylate and also a mixture of two or more second acrylates. A mixture of two or more second acrylates is preferred.

Component (B1) and component (B2) can be the same or different from each other.

Preferably, component (B1) and component (B2) are independently from one and another selected from the group consisting of acrylates and methacrylates.

Another object of the present invention is therefore a method wherein component (B1) and component (B2) are independently from one another selected from the group consisting of acrylates and methacrylates.

Suitable acrylates and methacrylates are known to the skilled person.

Acrylates and methacrylates will be summarized as (meth)acrylates hereinafter.

Suitable (meth)acrylates are mono(meth)acrylates as well as polyfunctional (meth)acrylates.

Another object of the present invention is therefore also a method wherein component (B1) and component (B2) are independently from one another selected from the group consisting of mono(meth)acrylates and polyfunctional (meth)acrylates.

Suitable mono(meth)acrylates are known to the skilled person. Suitable mono(meth)acrylates are preferably selected from the group consisting of isobornyl (meth)acrylate, bornyl (meth)acrylate, tricyclodecanyl (meth)acrylate, dicyclopentanyl (meth)acrylate, dicyclopentenyl (meth)acrylate, cyclohexyl (meth)acrylate, benzyl (meth)acrylate, 4-butylcyclohexyl (meth)acrylate, acryloyl morpholine, (meth)acrylic acid, 2-hydroxyethyl (meth)acrylate, 2-hydroxypropyl (meth)acrylate, 2-hydroxybutyl (meth)acrylate, methyl (meth)acrylate, ethyl (meth)acrylate, propyl (meth)acrylate, isopropyl (meth)acrylate, butyl (meth)acrylate, amyl (meth)acrylate, isobutyl (meth)acrylate,t-butyl (meth)acrylate, pentyl (meth)acrylate, caprolactone acrylate, isoamyl (meth)acrylate, hexyl (meth)acrylate, heptyl (meth)acrylate, octyl (meth)acrylate, isooctyl (meth)acrylate, 2-ethylhexyl (meth)acrylate, nonyl (meth)acrylate, decyl (meth)acrylate, isodecyl (meth)acrylate, tridecyl (meth)acrylate, undecyl (meth)acrylate, lauryl (meth)acrylate, stearyl (meth)acrylate, isostearyl (meth)acrylate, tetrahydrofurfuryl (meth)acrylate, butoxyethyl (meth)acrylate, ethoxydiethylene glycol (meth)acrylate, benzyl (meth)acrylate, phenoxyethyl (meth)acrylate, polyethylene glycol mono(meth)acrylate, polypropylene glycol mono(meth)acrylate, methoxyethylene glycol (meth)acrylate, ethoxyethyl (meth)acrylate, methoxypolyethylene glycol (meth)acrylate, methoxypolypropylene glycol (meth)acrylate, diacetone (meth)acrylamide, beta-carboxyethyl (meth)acrylate, phthalic acid (meth)acrylate, dimethylaminoethyl (meth)acrylate, diethylaminoethyl (meth)acrylate, butylcarbamylethyl (meth)acrylate,n-isopropyl (meth)acrylamide fluorinated (meth)acrylate and 7-amino-3,7-dimethyloctyl (meth)acrylate.

Suitable polyfunctional (meth)acrylates are as well known to the skilled person and are, for example, selected from the group consisting of trimethylolpropane tri(meth)acrylate, pentaerythritol (meth)acrylate, ethylene glycol di(meth)acrylate, bisphenol A diglycidyl ether di(meth)acrylate, dicyclopentadiene dimethanol di(meth)acrylate, [2-[1,1-dimethyl-2-[(1-oxoallyl)oxy]ethyl]-5-ethyl-1,3-dioxan-5-yl]methyl acrylate; 3,9-bis(1,1-dimethyl-2-hydroxyethyl)-2,4,8,10-tetraoxaspiro[5.5]undecane di(meth)acrylate; dipentaerythritol monohydroxypenta(meth)acrylate, propoxylated trimethylolpropane tri(meth)acrylate, ethoxylated trimethylolpropane tri(meth)acrylate, propoxylated neopentyl glycol di(meth)acrylate, tetraethylene glycol di(meth)acrylate, polyethylene glycol di(meth)acrylate, 1,4-butanediol di(meth)acrylate, 1,6-hexanediol di(meth)acrylate, neopentyl glycol di(meth)acrylate, polybutanediol di(meth)acrylate, tripropyleneglycol di(meth)acrylate, glycerol tri(meth)acrylate, phosphoric acid mono- and di(meth)acrylates, C7-C20alkyl di(meth)acrylates,tris(2-hydroxyethyl)isocyanurate tri(meth)acrylate,tris(2-hydroxyethyl)isocyanurate di(meth)acrylate, pentaerythritol tri(meth)acrylate, pentaerythritol tetra(meth)acrylate, dipentaerythritol hexa(meth)acrylate, tricyclodecane diyl dimethyl di(meth)acrylate and alkoxylated versions (e.g., ethoxylated and/or propoxylated) of any of the preceding monomers, and also di(meth)acrylate of a diol which is an ethylene oxide or propylene oxide adduct to bisphenol A, di(meth)acrylate of a diol which is an ethylene oxide or propylene oxide adduct to hydrogenated bisphenol A, epoxy (meth)acrylate which is a (meth)acrylate adduct to bisphenol A of diglycidyl ether, diacrylate of polyoxyalkylated bisphenol A, and triethylene glycol divinyl ether, and adducts of hydroxyethyl acrylate.

Particularly preferred component (B1) and component (B2) are independently from one another selected from the group consisting of bisphenol A diglycidyl ether di(meth)acrylate, ethoxylated or propoxylated bisphenol A or bisphenol F di(meth)acrylate, dicyclopentadiene dimethanol di(meth)acrylate, [2-[1,1-dimethyl-2-[(1-oxoallyl)oxy]ethyl]-5-ethyl-1,3-dioxan-5-yl]methyl acrylate, dipentaerythritol monohydroxypenta(meth)acrylate, dipentaerythritol penta(meth)acrylate, dipentaerythritol hexa(meth)crylate, propoxylated trimethylolpropane tri(meth)acrylate, 1,6-hexanediol di(meth)acrylate, ethoxylated trimethylolpropane tri(meth)acrylate, and propoxylated neopentyl glycol di(meth)acrylate, and any combination thereof.

Most preferably component (B1) and component (B2) are independently from one another selected from the group consisting of ethoxylated trimethylolpropane tri(meth)acrylate and 1,6-hexanediol di(meth)acrylate.

It is particularly preferred that component (B1) is 1,6-hexanediol di(meth)acrylate and component (B2) is a mixture of 1,6-hexanediol di(meth)acrylate and ethoxylated trimethylolpropane tri(meth)acrylate.

Another object of the present invention is therefore a method wherein component (B1) and component (B2) are independently from on another selected from the group consisting of bisphenol A diglycidyl ether di(meth)acrylate, ethoxylated or propoxylated bisphenol A or bisphenol F di(meth)acrylate, dicyclopentadiene dimethanol di(meth)acrylate, [2-[1,1-dimethyl-2-[(1-oxoallyl)oxy]ethyl]-5-ethyl-1,3-dioxan-5-yl]methyl acrylate, dipentaerythritol monohydroxypenta(meth)acrylate, dipentaerythritol penta(meth)acrylate, dipentaerythritol hexa(meth)crylate, propoxylated trimethylolpropane tri(meth)acrylate, 1,6-hexanediol di(meth)acrylate, ethoxylated trimethylolpropane tri(meth)acrylate, and propoxylated neopentyl glycol di(meth)acrylate, and any combination thereof.

Preferably, component (B1) and component (B2) have independently from one another a C-C-double bond functionality in the range from ≥ 1 to 6, more preferably in the range from 1 to 4 and particularly preferably in the range from 2 to 3.

Another object of the present invention is therefore a method wherein component (B1) and component (B2) have independently from one another a C-C-double bond functionality in the range from ≥ 1 to 6.

The C-C-double bond functionality within the context of the present invention means the number of acryloyl and methacryloyl units per molecule. Methods for the measurement of this C-C-double bond functionality are known to the skilled person.

If component (B1) is a mixture of two or more first acrylates and/or component (B2) is a mixture of two or more second acrylates then the C-C-double bond functionality is the average over all acryloyl and methacryloyl units per molecule.

### Component (C)

Component (C) is at least one dispersant.

"At least one dispersant" within the context of the present invention means precisely one dispersant and also a mixture of two or more dispersants.

Suitable dispersants are known to the skilled person. Preferably, component (C) is selected from the group consisting of ethoxylated fatty alcohols, polyoxypropylene/ethylene block copolymers, ethoxylated nonylphenol, (polyethylenglycol) p-octylphenylether, alkoxylated diamines, sodium lauryl sulfate and cationic dispersants. Cationic dispersants are particularly preferred.

Another object of the present invention is therefore also a method wherein component (C) is selected from the group consisting of ethoxylated fatty alcohols, polyoxyproylene/ethylene block copolymers, ethoxylated nonylphenol, (polyethylene glycol) p-octyl phenyl ether, alkoxylated diamines, sodium lauryl sulfate and cationic dispersants.

Suitable cationic dispersants are known to the skilled person. Preference is given to alkoxylated quaternary ammonium salts, especially to polypropoxy quarternary ammonium chlorides. Therefore, component (C) is preferably selected from the group consisting of polypropoxy quarternary ammonium chlorides. Polypropoxy quarternary ammonium chlorides are known under the trade name Variquat® by Evonik (preferably to Variquat CC NS 42).

For component (C2) optionally comprised in the solution (S), the above described embodiments and preferences for component (C) hold true.

### Component (D)

Component (D) is at least one photoinitiator.

"At least one photoinitiator" within the context of the present invention means precisely one photoinitiator and also a mixture of two or more photoinitiators.

A photoinitiator within the context of the present invention is a molecule that creates reactive species when exposed to UV radiation.

As component (D) any photoinitiator is suitable which creates a reactive species when exposed to UV radiation.

Preferably, component (D) is selected from the group consisting of benzophenone, alkylbenzophenones, halomethylated benzophenones, Michler's ketone, benzoin, benzoin ethers, benzylketals, acetophenone derivatives, phenylglyoxylic acid, antraquinone, methylantraquinone, acyl phosphine oxides and bisacylphosphine oxides. Particular preference is given to acetophenone derivatives.

Another object of the present invention is therefore a method wherein component (D) is selected from the group consisting of benzophenone, alkylbenzophenones, halomethylated benzophenones, Michler's ketone, benzoin, benzoin ethers, benzyl ketals, acetophenone derivatives, phenylglyoxylic acid, anthraquinone, methylanthraquinone, acylphosphine oxides and bisacylphosphine oxides.

Preferred components (D) are alpha-hydroxy ketones, mono- and bis-acyl phosphine oxides.

The preferred components (D) described above, are known to the person skilled in the art. Michler's ketone is also known as 4,4'-bis(N,N-dimethylamino)benzophenone.

Preferred acylphosphine oxides are 2,4,6-trimethylbenzoyldiphenylphosphine oxide and ethyl-2,4,6-trimethylbenzoylphenylphosphinate. An example of a bisacylphosphine oxide is bis(2,4,6-trimethylbenzoyl)phenylphosphine oxide.

Examples of acetophenone derivatives are hydroxy-2-methyl-1-phenylpropan-1-one and hydroxycyclohexyl phenyl ketone.

Benzophenone, acetophenone, acetonaphthoquinone, methyl ethyl ketone, valerophenone, hexanophenone, α-phenylbutyrophenone, p-morpholinopropiophenone, dibenzosuberone, 4-morpholinobenzophenone, 4-morpholinodeoxybenzoin, p-diacetylbenzene, 4-aminobenzophenone, 4'-methoxyacetophenone, β-methyianthraquinone, tert-butylanthraquinone, anthraquinonecarboxylic acid esters, benzaldehyde, α-tetralone, 9-acetylphenanthrene, 2-acetylphenanthrene, 10-thioxanthenone, 3-acetylphenanthrene, 3-acetylindole, 9-fluorenone, 1-indanone, 1,3,4-triacetylbenzene, thioxanthen-9-one, xanthen-9-one, 2,4-dimethylthioxanthone, 2,4-diethylthioxanthone, 2,4-diisopropylthioxanthone, 2,4-dichlorothioxanthone, hydroxycyclohexyl phenyl ketone, benzoin, benzoin isobutyl ether, chloroxanthenone, benzoin tetrahydropyranyl ether, benzoin methyl ether, benzoin ethyl ether, benzoin butyl ether, benzoin isopropyl ether, 7H-benzoin methyl ether, benz[de]anthracen-7-one, 1-naphthaldehyde, 4,4'-bis(dimethylamino)benzophenone, 4-phenylbenzophenone, 4-chlorobenzophenone, Michler's ketone, 1-acetonaphthone, 2-acetonaphthone, 1-benzoylcyclohexan-1-ol, 2-hydroxy-2,2-dimethylacetophenone, 2,2-dimethoxy-2-phenylacetophenone, 2,2-diethoxy-2-phenylacetophenone, 1,1-dichloroacetophenone, 1-hydroxyacetophenone, acetophenone dimethyl ketal, o-methoxybenzophenone, triphenylphosphine, tri-o-tolylphosphine, benz[a]anthracene-7,12-dione, 2,2-diethoxyacetophenone, benzil ketals, such as benzil dimethyl ketal, 2-methyl-1-[4-(methylthio)phenyl]-2-morpholinopropan-1-one, anthraquinones, such as 2-methylanthraquinone, 2-ethylanthraquinone, 2-tert-butylanthraquinone, 1-chloroanthraquinone, 2-amylanthraquinone and 2,3-butanedione may be mentioned as examples for component (D).

Particularly preferred, componente (D) is hydroxycyclohexyl phenyl ketone. Hydroxycyclohexyl phenyl ketone is known under the trade name Irgacure® 184 by BASF SE.

### Step c)

In step c) the ceramic dispersion (CD) provided in step a) and the solution (S) provided in step b) are mixed to obtain the photocurable formulation (F).

The ceramic dispersion (CD) and the solution (S) can be mixed by any method known to the skilled person. Preferred are commonly known mixing devices for example, planetary mixers, propeller stirrers and dispersion disks. The ceramic dispersion (CD) and the solution (S) are given into the mixing container in any order and are mixed for at least 30 min to 2 hours, depending on the mixing device. High shear rates and prolonged mixing times promote stability of the photocurable formulation (F).

The mixing of the ceramic dispersion (CD) and the solution (S) can be carried out at any temperature preferably below 60 °C. Preferably, the mixing is carried out at a temperature in the range from 15 to 50 °C, particularly preferably in the range from 17 to 35 °C and most preferably in the range from 20 to 30 °C.

Another object of the present invention is therefore a method wherein the mixing of the ceramic dispersion (CD) provided in step a) and the solution (S) provided in step b) to obtain the photocurable formulation (F) in step c) is carried out at a temperature in the range from 15 to 40 °C.

The ceramic dispersion (CD) and the solution (S) can be mixed in any ratio in step c). Preferably, in step c) in the range from 75 to 99 % by weight of the ceramic dispersion (CD) and in the range from 1 to 25 % by weight of the solution (S) are mixed to obtain the photocurable formulation (F), based on the sum of the percent by weight of the ceramic dispersion (CD) and the solution (S).

Particularly preferred in step c) in the range from 85 to 95 % by weight of the ceramic dispersion (CD) and in the range from 5 to 15 % by weight of the solution (S) are mixed to obtain the photocurable formulation (F), based on the sum of the percent by weight of the ceramic dispersion (CD) and the solution (S).

Another object of the present invention is therefore a method wherein in step c) in the range from 75 to 99 % by weight of the ceramic dispersion (CD) and in the range from 1 to 25 % by weight of the solution (S) are mixed to obtain the photocurable formulation (F), based on the sum of the percent by weight of the ceramic dispersion (CD) and the solution (S).

### Photocurable formulation (F)

In step c) the photocurable formulation (F) is obtained.

The photocurable formulation (F) comprises the components comprised in the ceramic dispersion (CD) and in the solution (S). The photocurable formulation (F) can comprise the components in reacted and/or in unreacted form. Preferably, the photocurable formulation (F) comprises the components in unreacted form.

If the ceramic dispersion (CD) comprises a further additive and/or the solution (S) comprises at least one additive and/or component (C2), then the photocurable formulation (F) obtained in step c) typically comprises the further additive and/or component (C2) and/or the at least one additive as well.

For example, the photocurable formulation (F) comprises from 72 to 83 % by weight of component (A), from 14 to 25 % by weight of components (B1) and (B2), from 0.8 to 6.0 % by weight of component (C) and from 0.1 to 2.0 % by weight of component (D), based on the sum of the percent by weight of components (A), (B1), (B2), (C) and (D), preferably based on the total weight of the photocurable formulation (F).

The viscosity of the formulation is preferably in the range from 0.1 to 3 Pas, particularly preferably in the range from 0.15 to 2.8 Pas and most preferably in the range from 0.2 to 2.5 Pas measured with a Brookfield viscosimeter (spindle type 62 at 12 rpm) at a temperature of 25°C.

The photocurable formulation (F) is preferably stable against sedimentation during the additive manufacturing process for at least twelve hours at temperatures in the range from 20 to 30 °C.

### Additive manufacturing process

In an additive manufacturing process comprising the steps
i) providing a photocurable formulation (F) obtainable by the method according to claims 1 to 10,
ii) forming a layer of a first part of the photocurable formulation (F) provided in step i), and curing at least a part of the layer formed using an UV-light source to obtain the molding,
a molding can be produced.

An additive manufacturing process is known to the skilled person and, for example, described in US 4,575,330.

In step i), the inventive photocurable formulation (F) is provided. The photocurable formulation (F) can be provided in step i) by any method known to the skilled person. Preferably, the photocurable formulation (F) is provided in liquid state. Particularly preferably, the photocurable formulation (F) is provided in liquid state in a container. Suitable containers are known to the skilled person.The container preferably comprises a working surface.

In step ii), a layer of a first part of the photocurable formulation (F) is formed and at least a part of the layer is cured using a UV light source. The layer of the first part of the photocurable formulation (F) is preferably formed by using the working surface. The layer has preferably a thickness in the range from 50 to 150 µm, particularly preferably in the range from 70 to 130 µm and most preferably in the range from 80 to 120 µm.

The layer of the first part of the photocurable formulation is then cured by exposure to a UV light source.

Preferred UV light sources are UV lasers, UV lamps and UV light emitting diodes.

During the curing, radicals of the at least one photoinitiator (component (D)) form and initiate the polymerization of the at least one first acrylate and the at least one second acrylate. This leads to a hardening of the photocurable formulation (F) due to the polymerization of components (B1) and (B2).

Preferably, in a second step, a second layer of a second part of the photocurable formulation (F) is formed. This second layer is typically formed by moving the working surface downwards so that the liquid photocurable formulation (F) comprised in the container flows onto the working surface and onto the cured part of the photocurable formulation (F). The layer is typically leveled using a recoater blade.

Therefore, preferably, step ii) comprises the following steps:
ii-1) forming a layer of a first part of the photocurable formulation (F) provided in step i),
ii-2) curing at least a part of the layer of the first part of the photocurable formulation (F) formed in step ii-1) using a UV light source to obtain a cured layer,
ii-3) forming a second layer of a second part of the photocurable formulation (F) provided in step i) on the cured layer obtained in step ii-2),
ii-4) curing at least a part of the second layer of the second part of the photocurable formulation (F) formed in step ii-3) using a UV light source to obtain the molding.

Preferably, steps ii-1) and ii-2) are repeated at least once.

The molding obtained in step ii) usually comprises uncured photocurable formulation (F) on its surface. This uncured photocurable formulation (F) can be removed by washing the obtained molding with a water-soluble organic solvent. Suitable water-soluble organic solvents are known to the skilled person. Preferred water-soluble organic solvents are glycols and derivatives thereof. Particular preference is given to tripropylene glycol methyl ether. After washing with the water-soluble organic solvent, the molding is preferably washed with water and then dried.

The present invention is illustrated below by reference to examples without limitation thereto.

### Examples

### Ceramic dispersion (CD)

The ceramic dispersion was prepared by mixing 86.7 % by weight of a silica (SiO₂) powder with a D50 value of 9 µm as component (A) with 1.73 % by weight of a polypropoxy quaternary ammonium chloride (trade name: Variquat CC NS 42 by Evonik) as component (C) in hexanediol diacrylate (trade name: Laromer HDDA by BASF SE) as component (B1), using a double helix mixer (helix pitch 1:1, agitator diameter 12.5 inches) at agitator speeds up to 100 rpm as high-shear dispersion equipment.

The mixing procedure was carried out in a 10 gallon reactor. Component (B1) and component (C) were poured into a vessel and mixed at minimum speed (15 - 20 rpm). Component (A) was then added stepwise while mixing at minimum speeds. Temperature control was used to keep the batch temperature below 35°C. After addition of component (A) the mixture was stirred for 2 hours at a speed determined based on torque. It was desired to keep the torque below 90 ft-lb.

The obtained ceramic dispersion (CD) had a viscosity of 21 Pas measured with a Brookfield viscosimeter (spindle type 64 at 6 rpm) at a temperature of 25 °C.

No sediment formation on the bottom of the holding jar filled to a height of 10 cm was obtained, no agglomerates were visible in light-microscopic observations of material drawn-downs and no significant change of viscosity with age was obtained. The ceramic dispersion (CD) was stable for at least twelve weeks while submitted to cyclic temperature changes (cycle: 6 hours holding at -20 °C, 6 hours ramp-up to 50 °C, 6 hours holding at 50 °C, 6 hours ramp-down to -20 °C).

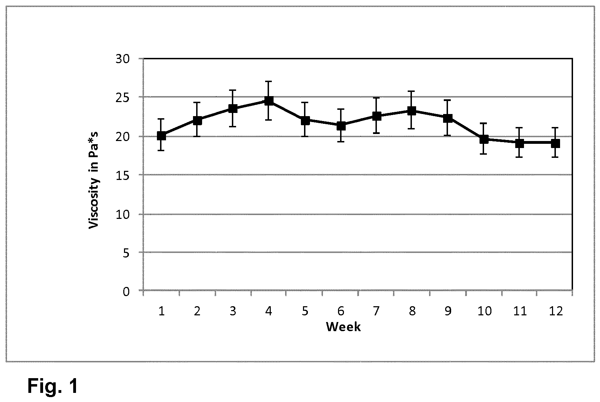

In figure 1 the viscosity of the obtained ceramic dispersion (CD) over twelve weeks is shown. It can be seen that the viscosity is constant over the time within the standard deviation.

### Photocurable formulation (F)

The obtained ceramic dispersion (CD) was mixed with a solution (S) comprising hexanediol diacrylate (trade name: Laromer® HDDA by Evonik) and ethoxylated trimethylolpropane triacrylate (trade name: Laromer® LR 8863 by Evonik) as component (B2), hydroxycyclohexyl phenyl ketone (trade name: Irgacure® 184 by BASF SE) as component (D), polypropoxy quaternary ammonium chloride (trade name: Variquat® CC NS 42 by Evonik) as dispersant and 2-(2H-benzotriazol-2-yl)-4-methyl-phenol (trade name: Tinuvin® 171 by BASF SE) as UV absorber to obtain the photocurable formulation (F). The obtained photocurable formulation (F) had the following composition: 80 % by weight of the ceramic powder, 1.6 % by weight of polypropoxy quaternary ammonium chloride, 15.5 % by weight of hexanediol diacrylcate, 1.94 % by weight of ethoxylated trimethylolpropane triacrylate, 1.05 % by weight of hydroxycyclohexyl phenyl ketone and 0.04 % by weight of 2-(2H-benzotriazol-2-yl)-4-methyl-phenol. The mixing of the ceramic dispersion (CD) and the solution (S) was performed using a dispersion disk (diameter: 4 cm) at 800 rpm for 30 minutes.

The obtained photocurable formulation (F) had a viscosity of 2.1 Pas measured with a Brookfield viscosimeter (spindle type 62 at 12 rpm) at 25°C.

The photocurable formulation's (F) stability was defined as the start time of sediment formation at room temperature (20 °C). The sediment formation was tested by scratching the bottom of a holding jar that was filled to a height of 10 cm with photocurable formulations (F) with a spatula. The photocurable formulation (F) was stable for twelve hours.

The photocurable formulation (F) was used in a stereolithography apparatus (Raplas RPS450) to obtain a molding. The molding was then cleaned of unreacted material by rinsing and gentle brushing with tripropylene glycol methyl ether (TPM), followed by a rinse with water. The obtained molding showed high precision and low curl distortion.

## Claims

1. A method for the production of a photocurable formulation (F) for the use in an additive manufacturing process, comprising the steps
a) provision of a ceramic dispersion (CD) comprising the following components
(A) at least one ceramic material having a D50 value of at least 2 µm,
(B1) at least one first acrylate
(C) at least one dispersant
b) provision of a solution (S) comprising the following components
(B2) at least one second acrylate
(D) at least one photoinitiator
c) mixing the ceramic dispersion (CD) provided in step a) and the solution (S) provided in step b) to obtain the photocurable formulation (F).

2. The method according to claim 1, wherein component (A) is selected from the group consisting of SiO₂, ZrO₂, Al₂O₃, ZnO, Fe₂O₃, Fe₃O₄, Y₂O₃, TiO₂, SiC, Si₃N₄, TiB and AlN.

3. The method according to claim 1 or 2, wherein component (B1) and component (B2) are independently from one another selected from the group consisting of acrylates and methacrylates.

4. The method according to any one of claims 1 to 3, wherein component (C) is selected from the group consisting of ethoxylated fatty alcohols, polyoxyproylene/ethylene block copolymers, ethoxylated nonylphenol, (polyethylene glycol) p-octyl phenyl ether, alkoxylated diamines, sodium lauryl sulfate and cationic dispersants.

5. The method according to any one of claims 1 to 4, wherein component (D) is selected from the group consisting of benzophenone, alkylbenzophenones, halomethylated benzophenones, Michler's ketone, benzoin, benzoin ethers, benzyl ketals, acetophenone derivatives, phenylglyoxylic acid, anthraquinone, methylanthraquinone, acylphosphine oxides and bisacylphosphine oxides.

6. The method according to any one of claims 1 to 5, wherein the ceramic dispersion (CD) provided in step a) comprises in the range from 57 to 90 % by volume of component (A) in the range from 10 to 42 % by volume of component (B1) and in the range from 0.1 to 15 % by volume of component (C), based on the sum of the percent by volume of components (A), (B1) and (C).

7. The method according to any one of claims 1 to 6, wherein the solution (S) provided in step b) comprises in the range from 75 to 99.9 % by weight of component (B2) and in the range from 0.1 to 25 % by weight of component (D), based on the sum of the percent by weight of components (B2) and (D).

8. The method according to any one of claims 1 to 7, wherein component (B1) and component (B2) have independently from one another a C-C-double bond functionality in the range from ≥ 1 to 6.

9. The method according to any one of claims 1 to 8, wherein the solution (S) provided in step b) furthermore comprises component (C2) at least one dispersant.

10. The method according to any one of claims 1 to 9, wherein in step c) in the range from 75 to 99 % by weight of the ceramic dispersion (CD) and in the range from 1 to 25 % by weight of the solution (S) are mixed to obtain the photocurable formulation (F), based on the sum of the percent by weight of the ceramic dispersion (CD) and the solution (S).

## Patentansprüche

1. Verfahren zur Herstellung einer lichthärtbaren Formulierung (F) zur Verwendung bei einem Additivherstellungsprozess, das die folgenden Schritte umfasst:
a) Bereitstellung einer Keramikdispersion (KD), die die folgenden Komponenten umfasst:
(A) mindestens ein Keramikmaterial mit einem D50-Wert von mindestens 2 µm,
(B1) mindestens ein erstes Acrylat,
(C) mindestens ein Dispergiermittel,
b) Bereitstellung einer Lösung (L), die die folgenden Komponenten umfasst:
(B2) mindestens ein zweites Acrylat,
(D) mindestens einen Photoinitiator,
c) Mischen der in Schritt a) bereitgestellten Keramikdispersion (KD) und der in Schritt b) bereitgestellten Lösung (L) zum Erhalt der lichthärtbaren Formulierung (F).

2. Verfahren nach Anspruch 1, wobei die Komponente (A) aus der Gruppe bestehend aus SiO₂, ZrO₂, Al₂O₃, ZnO, Fe₂O₃, Fe₃O₄, Y₂O₃, TiO₂, SiC, Si₃N₄, TiB und AlN ausgewählt ist.

3. Verfahren nach Anspruch 1 oder 2, wobei Komponente (B1) und Komponente (B2) unabhängig voneinander aus der Gruppe bestehend aus Acrylaten und Methacrylaten ausgewählt sind.

4. Verfahren nach einem der Ansprüche 1 bis 3, wobei Komponente (C) aus der Gruppe bestehend aus ethoxylierten Fettalkoholen, Polyoxyproylen/-ethylen-Blockcopolymeren, ethoxyliertem Nonylphenol, (Polyethylenglykol)-p-octylphenylether, alkoxylierten Diaminen, Natriumlaurylsulfat und kationischen Dispergiermitteln ausgewählt ist.

5. Verfahren nach einem der Ansprüche 1 bis 4, wobei Komponente (D) aus der Gruppe bestehend aus Benzophenon, Alkylbenzophenonen, halogenmethylierten Benzophenonen, Michlers Keton, Benzoin, Benzoinethern, Benzylketalen, Acetophenonderivaten, Phenylglyoxylsäure, Anthrachinon, Methylanthrachinon, Acylphosphinoxiden und Bisacylphosphinoxiden ausgewählt ist.

6. Verfahren nach einem der Ansprüche 1 bis 5, wobei die in Schritt a) bereitgestellte Keramikdispersion (KD) die Komponente (A) im Bereich von 57 bis 90 Volumen-%, die Komponente (B1) im Bereich von 10 bis 42 Volumen-% und die Komponente (C) im Bereich von 0,1 bis 15 Volumen-%, bezogen auf die Summe der Volumenprozente der Komponenten (A), (B1) und (C), umfasst.

7. Verfahren nach einem der Ansprüche 1 bis 6, wobei die in Schritt b) bereitgestellte Lösung (L) die Komponente (B2) im Bereich von 75 bis 99,9 Gewichts-% und die Komponente (D) im Bereich von 0,1 bis 25 Gewichts-%, bezogen auf die Summe der Gewichtsprozente der Komponenten (B2) und (D), umfasst.

8. Verfahren nach einem der Ansprüche 1 bis 7, wobei Komponente (B1) und Komponente (B2) unabhängig voneinander eine C-C-Doppelbindungsfunktionalität im Bereich von ≥ 1 bis 6 aufweisen.

9. Verfahren nach einem der Ansprüche 1 bis 8, wobei die in Schritt b) bereitgestellte Lösung (L) ferner die Komponente (C2), mindestens ein Dispergiermittel, umfasst.

10. Verfahren nach einem der Ansprüche 1 bis 9, wobei in Schritt c) die Keramikdispersion (KD) im Bereich von 75 bis 99 Gewichts-% und die Lösung (L) im Bereich von 1 bis 25 Gewichts-%, bezogen auf die Summe der Gewichtsprozente der Keramikdispersion (KD) und der Lösung (L), zum Erhalt der lichthärtbaren Formulierung (F) gemischt werden.

## Revendications

1. Procédé de production d'une formulation photodurcissable (F) pour utilisation dans un procédé de fabrication additive, comprenant les étapes de
a) fourniture d'une dispersion de céramique (CD) comprenant les composants suivants
(A) au moins un matériau céramique ayant une valeur D50 d'au moins 2 µm,
(B1) au moins un premier acrylate
(C) au moins un dispersant
b) fourniture d'une solution (S) comprenant les composants suivants
(B2) au moins un deuxième acrylate
(D) au moins un photoamorceur
c) mélange de la dispersion de céramique (CD) produite dans l'étape a) et de la solution (S) produite dans l'étape b) pour obtenir la formulation photodurcissable (F) .

2. Procédé selon la revendication 1, dans lequel le composant (A) est choisi dans le groupe constitué de SiO₂, ZrO₂, Al₂O₃, ZnO, Fe₂O₃, Fe₃O₄, Y₂O₃, TiO₂, SiC, Si₃N₄, TiB et AlN.

3. Procédé selon la revendication 1 ou 2, dans lequel le composant (B1) et le composant (B2) sont, indépendamment l'un de l'autre, choisis dans le groupe constitué d'acrylates et de méthacrylates.

4. Procédé selon l'une quelconque des revendications 1 à 3, dans lequel le composant (C) est choisi dans le groupe constitué d'alcools gras éthoxylés, copolymères séquencés polyoxypropylène / éthylène, nonylphénol éthoxylé, éther p-octylphénylique de (polyéthylène glycol), diamines alcoxylées, laurylsulfate de sodium et dispersants cationiques.

5. Procédé selon l'une quelconque des revendications 1 à 4, dans lequel le composant (D) est choisi dans le groupe constitué des benzophénone, alkylbenzophénones, benzophénones halogénométhylées, cétone de Michler, benzoïne, éthers de benzoïne, benzylcétals, dérivés d'acétophénone, acide phénylglyoxylique, anthraquinone, méthylanthraquinone, oxydes d'acylphosphine et oxydes de bisacylphosphine.

6. Procédé selon l'une quelconque des revendications 1 à 5, dans lequel la dispersion de céramique (CD) produite dans l'étape a) comprend dans la plage de 57 à 90 % en volume de composant (A) dans la plage de 10 à 42 % en volume de composant (B1) et dans la plage de 0,1 à 15 % en volume de composant (C), sur la base de la somme du pourcentage en volume de composants (A), (B1) et (C).

7. Procédé selon l'une quelconque des revendications 1 à 6, dans lequel la solution (S) produite dans l'étape b) comprend dans la plage de 75 à 99,9 % en poids de composant (B2) et dans la plage de 0,1 à 25 % en poids de composant (D), sur la base de la somme du pourcentage en poids des composants (B2) et (D).

8. Procédé selon l'une quelconque des revendications 1 à 7, dans lequel le composant (B1) et le composant (B2) comportent, indépendamment l'un de l'autre, une fonctionnalité à double liaison C-C dans la plage de ≥ 1 à 6.

9. Procédé selon l'une quelconque des revendications 1 à 8, dans lequel la solution (S) produite dans l'étape b) comprend en outre le composant (C2), au moins un dispersant.

10. Procédé selon l'une quelconque des revendications 1 à 9, dans lequel, dans l'étape c), dans la plage de 75 à 99 % en poids de la dispersion de céramique (CD) et dans la plage de 1 à 25 % en poids de la solution (S) sont mélangés pour obtenir la formulation photodurcissable (F), sur la base de la somme du pourcentage en poids de la dispersion de céramique (CD) et de la solution (S).
